# EUROPEAN PATENT APPLICATION

(11) **EP 4 163 961 A1**
(43) Date of publication of application: **12.04.2023**
(21) Application number: 21817320.1
(22) Date of filing: 14.05.2021
(51) Int. Cl.: H01L 23/12

(54) **CIRCUIT BOARD**

(30) Priority: 03.06.2020 JP 2020096729
(71) Applicant: Sumitomo Bakelite Co., Ltd., Shinagawa-ku Tokyo 140-0002 (JP)
(72) Inventor: TAGASHIRA, Nobuo, Tokyo 140-0002 (JP)
(74) Representative: Ter Meer Steinmeister & Partner
(86) International application number: PCT/JP2021/018362
(87) International publication number: WO 2021/246136

(57) **Abstract**

A heat radiating substrate (10) (circuit board) includes: an insulating layer (11) (insulating substrate); and a circuit pattern (20) of a metal provided on the insulating layer (11) in direct contact with the insulating layer (11), in which the circuit pattern (20) has a first circuit pattern formed in a first region on the insulating layer (11) and a second circuit pattern (120) formed in a second region on the insulating layer (11), and the first region (that is, the first circuit pattern) surrounds and closes the second region (that is, second circuit pattern (120)) when viewed in a top view.

## Description

### TECHNICAL FIELD

The present invention relates to a circuit board.

### BACKGROUND ART

In recent years, the market for a power module on which an electronic component, such as an IGBT element, is mounted has been expanding. The power module is required to have high reliability and high heat resistance. As this kind of technology, various developments have been made so far in circuit boards (also referred to as heat radiating substrates) having a heat radiation function, and for example, a technology disclosed in Patent Document 1 is known. Patent Document 1 discloses a power module in which a semiconductor element is mounted on a support, such as a lead frame, and the support and a heat radiating plate connected to a heat sink are bonded to each other with an insulating resin layer.

### RELATED DOCUMENT

### PATENT DOCUMENT

[Patent Document 1] Japanese Unexamined Patent Publication No. 2011-216619

### SUMMARY OF THE INVENTION

### TECHNICAL PROBLEM

In recent years, higher quality and performance have been required for such circuit boards. In particular, having a high heat radiation performance is important in heat radiation design for the circuit board because an electronic component or the like that generates a large amount of heat is mounted thereon. In such a situation, a locally high region in heat distribution may lead to imbalance and warpage of the circuit board. Therefore, there has been a demand for a technology that enables flexible response in the heat radiation design for the circuit board. The technology disclosed in Patent Document 1 cannot sufficiently meet such a demand, and a new technology has been demanded.

The present invention has been made in view of such a situation, and an object of the present invention is to provide a technique of enhancing flexibility in heat radiation design in a circuit board having a heat radiation function.

### SOLUTION TO PROBLEM

It is possible to provide a circuit board including:
an insulating substrate; and
a circuit pattern of a metal provided on the insulating substrate in direct contact with the insulating substrate,
in which the circuit pattern has a first circuit pattern formed in a first region on the insulating substrate and a second circuit pattern formed in a second region on the insulating substrate, and
the first region surrounds and closes the second region when viewed in a top view.

### ADVANTAGEOUS EFFECTS OF INVENTION

According to the present invention, it is possible to provide a technique of enhancing flexibility in heat radiation design in a circuit board having a heat radiation function.

### BRIEF DESCRIPTION OF THE DRAWINGS

Fig. 1 is a plan view of a heat radiating substrate according to an embodiment.
Fig. 2 is a cross-sectional view of the heat radiating substrate according to the embodiment.
Fig. 3 is an enlarged view of a region X of Fig. 1 according to the embodiment.
Fig. 4 is a chart showing a production step of the heat radiating substrate according to the embodiment.
Fig. 5 is a view showing a cross-sectional structure of a circuit pattern according to the embodiment so as to be comparable with a conventional structure.

### DESCRIPTION OF EMBODIMENTS

Hereinafter, an embodiment of the present invention will be described with reference to the drawings.

### <Overview of Heat Radiating Substrate>

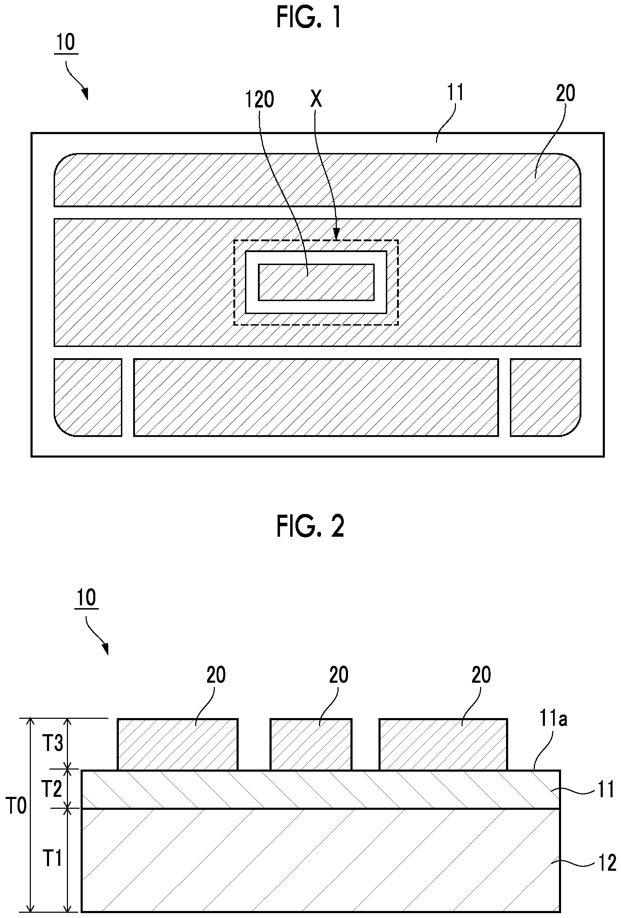

Fig. 1 is a plan view of a heat radiating substrate 10. Fig. 2 is a cross-sectional view of a part of the heat radiating substrate 10.

The heat radiating substrate 10 is a circuit board on which, for example, an electronic component of a heat-generating body is mounted, is composed of a metal substrate 12, an insulating layer 11, and a circuit pattern 20, and is a laminate (laminated body) laminated in this order from the bottom as shown in Fig. 2. The electronic component or the like is mounted on the circuit pattern 20. The circuit pattern 20 has an island-shaped (also referred to as a "floating island-shaped") circuit pattern (a second circuit pattern 120) formed in a region X provided in a substantially central part in the plan view (when viewed in a top view) of Fig. 1.

A total thickness T0 of the heat radiating substrate 10 is not particularly limited, but is, for example, preferably 300 um or more and 5000 um or less and more preferably 1000 um or more and 4000 um or less.

### <Metal Substrate 12>

The metal substrate 12 is a layer composed of a metal material, and in the present embodiment, the insulating layer 11 is formed on an upper surface thereof, and a heat radiating means (not shown), such as heat radiating fins and radiators, is appropriately attached to the lower surface thereof.

The metal material constituting the metal substrate 12 is not limited to a specific type, but for example, copper, a copper alloy, aluminum, an aluminum alloy, or the like can be used.

A thickness T1 of the metal substrate 12 is not particularly limited, but is the thickest among the elements (the insulating layer 11, the metal substrate 12, and the circuit pattern 20) laminated in the heat radiating substrate 10, and is preferably 10% to 90% with respect to the total thickness T0.

The upper limit value of the thickness T1 of the metal substrate 12 is, for example, 20.0 mm or less and preferably 5.0 mm or less. The metal substrate 12 having the thickness T1 equal to or less than the upper limit value is used, whereby the heat radiating substrate 10 as a whole can be made thinner. Further, it is possible to improve the workability in routing, cutting, or the like of the heat radiating substrate 10.

The lower limit value of the thickness T1 of the metal substrate 12 is, for example, 0.1 mm or more, preferably 0.5 mm or more, and more preferably 1.0 mm or more. The metal substrate 12 having the lower limit value or more is used, whereby the heat radiation properties of the heat radiating substrate 10 as a whole can be improved.

### <Insulating layer 11>

The insulating layer 11 is a layer of a resin substrate mainly containing a resin material, and has a function of insulating the metal substrate 12 from the circuit pattern 20. As the insulating layer 11, a ceramic substrate (an aluminum nitride substrate, a silicon nitride substrate, or the like) may be used instead of the resin substrate.

The resin material constituting the insulating layer 11 is not limited to a specific type, but examples thereof include a thermosetting resin, such as an epoxy resin, a phenol resin, a urea resin, a melamine resin, a polyester (unsaturated polyester) resin, or a polyimide resin, a silicone resin, and a polyurethane resin. As the resin material, one or a mixture of two or more of these resins can be used.

A filler composed of particles having electrical insulation properties and high thermal conductivity can also be mixed into the resin material constituting the insulating layer 11. Examples of the constituent material of the particles of the filler include metal oxides, such as alumina, and nitrides, such as boron nitride.

A thickness T2 of the insulating layer 11 is appropriately set according to the purpose, but the thickness T2 of the insulating layer 11 is preferably 40 um or more and 400 um or less from the viewpoint of more effectively transferring heat from the electronic component to the metal substrate 12 while improving the mechanical strength and heat resistance, and the thickness T2 of the insulating layer 11 is more preferably set to 80 µm or more and 300 µm or less from the viewpoint of further excellent balance between the heat radiation properties and the insulation properties in the entire heat radiating substrate 10. The thickness T2 of the insulating layer 11 is set to the above upper limit value or less, whereby it is possible to facilitate the transfer of heat from the electronic component to the metal substrate 12. In addition, the thickness T2 of the insulating layer 11 is set to the above lower limit value or more, whereby the insulating layer 11 can sufficiently alleviate the generation of thermal stress caused by a difference in coefficient of thermal expansion between the metal substrate 12 and the insulating layer 11. Further, the insulation properties of the heat radiating substrate 10 are improved.

### <Circuit Pattern 20>

The circuit pattern 20 is composed of a conductive metal material, and is electrically connected to an electronic component (LED or the like) of a heat-generating body by, for example, soldering. For example, copper can be suitably used as the metal material constituting the circuit pattern 20. With this, the circuit pattern 20 has a relatively small resistance value. At least a part of the circuit pattern 20 may be covered with a solder resist layer.

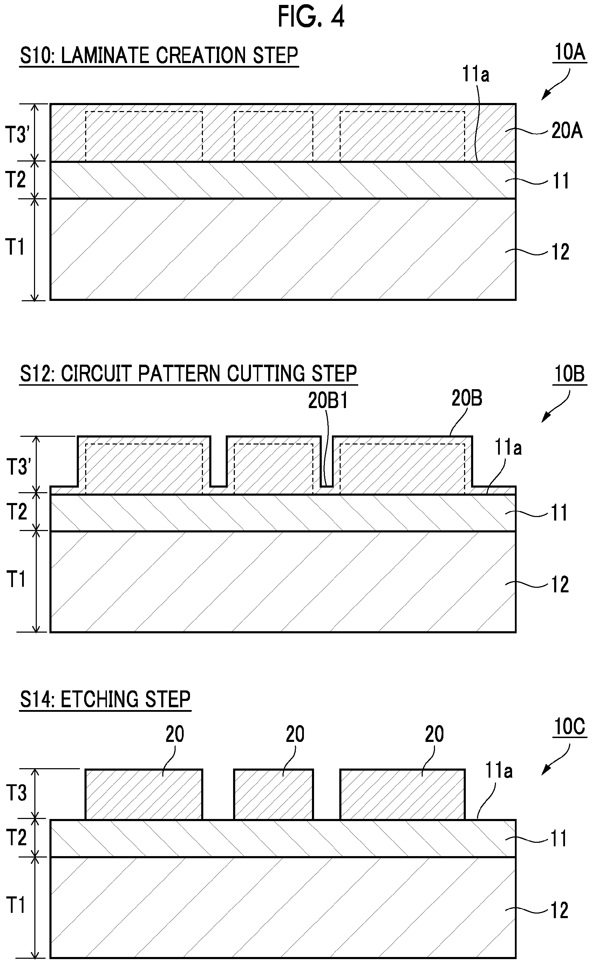

The circuit pattern 20 is formed, for example, by working a metal layer laminated on an insulating layer upper surface 11a of the insulating layer 11 into a predetermined pattern through cutting and etching. Although the formation process will be described later in Fig. 4, rolled copper is used as a metal layer 20A in the present embodiment.

The lower limit value of a thickness T3 of the circuit pattern 20 is, for example, 0.3 mm or more. In a case where the lower limit value is such a numerical value or more, it is possible to restrain the circuit pattern from generating heat even in a use requiring a high current. Further, the upper limit value of the thickness T3 of the circuit pattern 20 is, for example, 5.0 mm or less, preferably 4.0 mm or less, and more preferably 3.0 mm or less. In a case where the upper limit value is such a numerical value, the circuit workability can be improved, and the substrate as a whole can be made thinner.

### <Island-Shaped Circuit Pattern Shape>

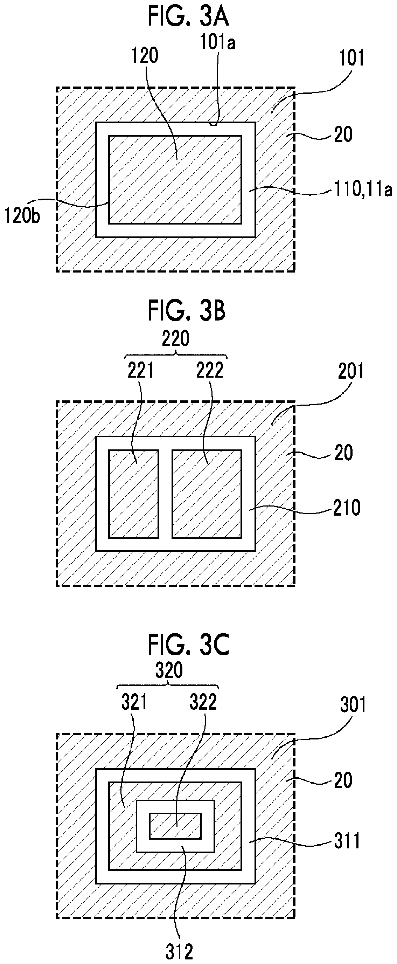

The detailed shape of the circuit pattern 20, particularly the island-shaped circuit pattern shown in the region X of Fig. 1, will be described with reference to Fig. 3. Figs. 3A to 3C are enlarged views of the island-shaped circuit pattern and show three aspects of Figs. 3A to 3C.

First, a basic aspect will be described with reference to Fig. 3A.

The circuit pattern 20 has a first circuit pattern 101 formed in a first region on the insulating layer 11 and the second circuit pattern 120 formed in a second region on the insulating layer 11, and the first region (that is, the first circuit pattern 101) surrounds and closes the second region (that is, the second circuit pattern 120) when viewed in a top view. Here, the first region on the insulating layer 11 refers to an interface between the insulating layer upper surface 11a and the first circuit pattern 101. In addition, the second region refers to an interface between the insulating layer upper surface 11a and the second circuit pattern 120.

Specifically, the second circuit pattern 120 has a shape (that is, an island shape) separated from the first circuit pattern 101 by an inter-circuit groove portion 110 which is formed in a rectangular annular shape when viewed in a plan view. The inter-circuit groove portion 110 is a region in which the circuit pattern 20 is not formed and the insulating layer upper surface 11a of the insulating layer 11 is exposed. The width of the inter-circuit groove portion 110 may be constant or may vary depending on the location.

Here, a contour line when the boundary between the first circuit pattern 101 and the inter-circuit groove portion 110 is viewed in a top view is set as an inner contour line 101a. A contour line when the boundary between the second circuit pattern 120 and the inter-circuit groove portion 110 is viewed in a top view is set as an outer contour line 120b. The area of a region surrounded by the inner contour line 101a of the first circuit pattern 101 is denoted by S₁, and the area surrounded by the outer contour line 120b of the second circuit pattern 120 is denoted by S₂. At this time, the ratio S₂/S₁ of the area S₂ to the area S₁ is 0.1 or more and 0.9 or less.

In the present embodiment, as will be described in the production process of Fig. 4, it is possible to form the metal layer 20A of rolled copper provided on the insulating layer 11 into the desired circuit pattern 20 by efficiently working the metal layer 20A through cutting and etching.

For example, the height (thickness) of the circuit pattern 20 is denoted by b, and the width of the inter-circuit groove portion 110 is denoted by a. Note that the width a is the distance between the middle portions in the height direction on the respective metal layer side surfaces of the first circuit pattern 101 and the second circuit pattern 120. In this condition, a region with an aspect ratio b/a of 0.2 or more and 5 or less is provided. In other words, the region is a region where the width a of the inter-circuit groove portion 110 is relatively narrow with respect to the height D (b) of the first circuit pattern 101 or the second circuit pattern 120.

In this manner, since the inter-circuit groove portion 110 can be provided with a narrower width than that of the conventional structure, the degree of freedom of the shape of the second circuit pattern 120 is increased. That is, the degree of freedom in the heat radiation design increases, and the controllability of the heat distribution in the entire heat radiating substrate 10 is improved when the electronic component or the like is mounted on the circuit pattern 20 and is driven.

As described above, the first circuit pattern 101 surrounds and closes the second circuit pattern 120 with the inter-circuit groove portion 110 interposed therebetween, but the height of the first circuit pattern 101 or the second circuit pattern 120 may not be necessarily constant. For example, a part thereof may be thinly formed in a recessed shape, whereby the heat distribution of the heat radiating substrate 10 can be controlled.

Next, Modification Example 1 of the island shape formed in the circuit pattern 20 will be described with reference to Fig. 3B.

In the circuit pattern 20 of Modification Example 1, a second circuit pattern 220 surrounded by a first circuit pattern 201 has a second circuit pattern (1) 221 and a second circuit pattern (2) 222 which are independently formed side by side on the left and right sides, and the second circuit pattern (1) 221 and the second circuit pattern (2) 222 are separated by an inter-circuit groove portion 210.

In Modification Example 1 as well, since the inter-circuit groove portion 210 can be provided with a narrower width than that of the conventional structure, the degree of freedom of the shape of the second circuit pattern 220 (the second circuit pattern (1) 221 and the second circuit pattern (2) 222) is increased. That is, the degree of freedom in the heat radiation design increases, and the controllability of the heat distribution in the entire heat radiating substrate 10 is improved when the electronic component or the like is mounted on the circuit pattern 20 and is driven. The number of island-shaped circuit patterns may be three or more. Further, the size and shape of each island-shaped circuit pattern may be different from each other. That is, an appropriate size and shape can be selected according to the design considering the required heat distribution.

Modification Example 2 of the island shape formed in the circuit pattern 20 will be described with reference to Fig. 3C.

In the circuit pattern 20 of Modification Example 2, a second circuit pattern 320 surrounded by a first circuit pattern 301 has a second circuit pattern (1) 321 surrounded and separated from the first circuit pattern 301 by a first inter-circuit groove portion 311, and a second circuit pattern (2) 322 surrounded and separated from the second circuit pattern (1) 321 by a second inter-circuit groove portion 312. That is, when viewed in a top view, the island-shaped second circuit pattern (2) 322 is further provided in the inner region of the island-shaped second circuit pattern (1) 321. Another island-shaped circuit pattern may be further formed in the inner region of the second circuit pattern (2) 322. Further, a plurality of the second circuit patterns (2) 322 may be formed in the inner region of the second circuit pattern (1) 321.

In Modification Example 2 as well, since the first inter-circuit groove portion 311 and the second inter-circuit groove portion 312 can be each provided with a narrower width than that of the conventional structure, the degree of freedom of the shape of the second circuit pattern 320 (the second circuit pattern (1) 321 and the second circuit pattern (2) 322) is increased. That is, the degree of freedom in the heat radiation design increases, and the controllability of the heat distribution in the entire heat radiating substrate 10 is improved when the electronic component or the like is mounted on the circuit pattern 20 and is driven.

### <Method of Producing Heat Radiating Substrate 10>

Fig. 4 is a chart showing the production process of the heat radiating substrate 10. A method of producing the heat radiating substrate 10 will be described with reference to Fig. 4.

### (S10: Laminated Body Preparation Step)

A laminate 10A in which the metal substrate 12, the insulating layer 11, and the metal layer 20A are laminated in this order from the bottom is prepared. The metal layer 20A is worked by the following steps to form the circuit pattern 20.

As the method of producing the laminate 10A, a known method can be used. For example, the metal substrate 12 is used as a carrier, and a liquid material (varnish-like material) as a constituent material of the insulating layer 11 is applied onto the metal substrate 12 having the thickness T1 by, for example, a spray method.

After that, the liquid material applied on the metal substrate 12 is dried by natural drying or forced drying. With this, the insulating layer 11 having the thickness T2 can be obtained. At this time, the insulating layer 11 may not be completely cured (so-called B stage state).

Next, the metal layer 20A having a thickness of T3' is formed on the insulating layer 11 (that is, the insulating layer upper surface 11a). That is, the metal layer 20A to be the circuit pattern 20, for example, rolled copper is laminated on the insulating layer upper surface 11a of the insulating layer 11 by a hot press or the like. With this, the laminate 10A can be obtained. The thickness T3' of the metal layer 20A is set in consideration of an etching step, which will be described later.

### (S12: Circuit Pattern Cutting Step)

Subsequently, the metal layer 20A of the above-described laminate 10A is cut so as to have a desired pattern by using a router. This pattern also includes a shape corresponding to the second circuit pattern 120 to be the island shape. A provisional circuit pattern 20B is formed on the insulating layer 11 by leaving a metal layer (thin copper portion 20B1) having a predetermined thickness for a portion that is not a pattern. That is, there is a concern that the insulating layer 11 may be damaged in a case where all the patterns are formed by cutting. Therefore, the metal layer (thin copper portion 20B1) having the thickness is partially left as a margin. With this, a laminate 10B having the provisional circuit pattern 20B can be obtained.

### (S14: Etching Step)

Further, the etching process is performed on the laminate 10B having the provisional circuit pattern 20B to melt the remaining metal layer (thin copper portion 20B1) and to form a desired pattern so that the final circuit pattern 20, that is, a pattern including the second circuit pattern 120 or the inter-circuit groove portion 110, can be obtained. With this, a heat radiating substrate 10C can be obtained. In the etching step, since the thickness of the thin copper portion 20B1 to be melted is sufficiently thin by the previous cutting step, only a very small region near the interface between the circuit pattern 20 and the insulating layer upper surface 11a has a trailing-tailed shape formed when the circuit pattern 20 is formed.

### <Effect of Embodiment>

The features and effects of the embodiment are summarized as follows.
(1) The heat radiating substrate 10 (circuit board) includes:
   the insulating layer 11 (insulating substrate); and
   the circuit pattern 20 of a metal provided on the insulating layer 11 in direct contact with the insulating layer 11,
   in which the circuit pattern 20 has the first circuit pattern 101 formed in the first region on the insulating layer 11 and the second circuit pattern 120 formed in the second region on the insulating layer 11, and
   the first region (that is, the first circuit pattern 101) surrounds and closes the second region (that is, the second circuit pattern 120) when viewed in a top view.
   In the circuit pattern 20, the island-shaped second circuit pattern 120 separated by the inter-circuit groove portion 110 is provided in the inner region when viewed in a top view, so that the flexibility (that is, the degree of freedom in design) of the heat radiation control of the heat radiating substrate 10 can be obtained. Specifically, it is not necessary to provide an open portion (discontinuous portion) in the first circuit pattern 101 surrounding the second circuit pattern 120 when providing the second circuit pattern 120. As a result, it is possible to realize a configuration in which the temperature distribution of the heat radiating substrate 10 does not become locally high when the electronic component or the like is mounted thereon.
(2) In the heat radiating substrate 10, when the area of the region surrounded by the outer contour line of the second region (the outer contour line 120b of the second circuit pattern 120) is denoted by S₂, and the area surrounded by the inner contour line of the first region (the inner contour line 20a of the first circuit pattern 101) is denoted by S₁, S₂/S₁ is 0.1 or more and 0.9 or less.

Since the width of the inter-circuit groove portion 110 can be narrowed, the degree of freedom in designing the island shape is increased, and the flexibility in the heat radiation design can be improved.

(3) In the heat radiating substrate 10, the insulating layer 11 consists of a resin substrate.

As described above, the degree of freedom in the heat radiation design increases, so that it is possible to restrain the occurrence of warpage caused by the difference in linear expansion coefficient between the circuit pattern 20, which is a metal layer, and the insulating layer 11, which is a resin substrate, for example, even in a case where the insulating layer 11 is the resin substrate.

(4) In the heat radiating substrate 10, the circuit pattern 20 consists of rolled copper.

The high degree of freedom in the heat radiation design and the high heat radiation performance can be realized even in a case where the circuit pattern 20 is made of a material with high thermal conductivity, such as rolled copper. In addition, since the distribution of heat generated during the mounting of the electronic component or the like can be averaged even in a case where there is a large difference in linear expansion coefficient between the insulating layer 11 and rolled copper, it becomes easier to predict the occurrence of warpage or the like and to take countermeasures.

### Examples

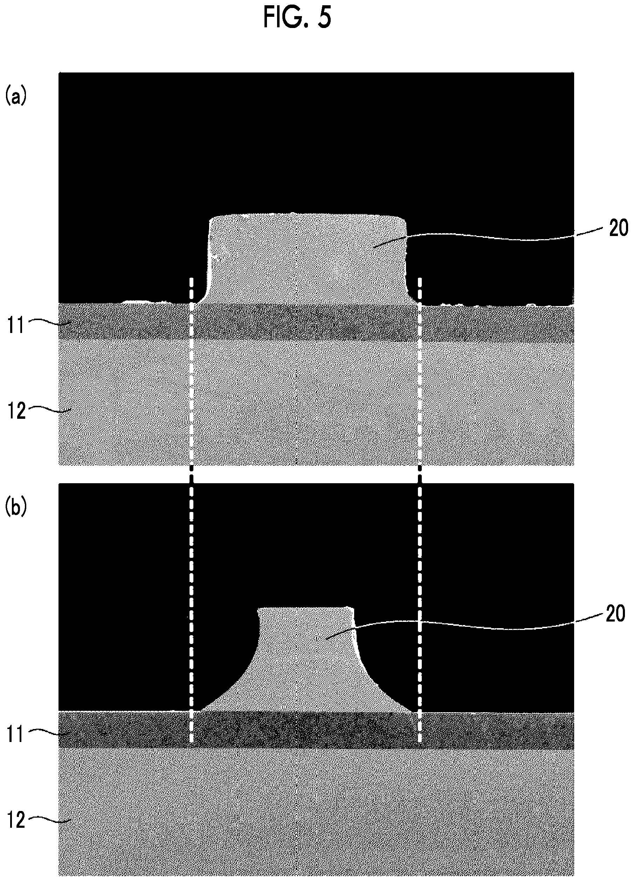

Fig. 5 shows photographs of cross-sectional structures of Example and Comparative Example. Fig. 5(a) is the heat radiating substrate 10 produced by forming the circuit pattern 20 by using the cutting and etching shown in the above-described embodiment (Example). Fig. 5(b) is a heat radiating substrate produced by forming the circuit pattern 20 by using only conventional general etching (Comparative Example). Here, the photographs of the circuit cross-sections are vertically arranged so as to be comparable with each other. In these photographs, the width of the circuit pattern 20, more specifically, the width of a metal layer lower surface 22 (the interface with the insulating layer 11) is formed to be 1 mm.

In Comparative Example shown in Fig. 5(b), the side surface portion has a trailing-tailed shape (substantially Mt. Fuji shape) as a whole, and the area of the upper surface of the circuit pattern 20 is narrowed. On the other hand, in Example shown in Fig. 5(a), the region of the side surface portion with the trailing-tailed shape (trailing-tailed part 23a in Fig. 3) is small, and most of the region forms a straight line (straight line part 23b in Fig. 3). Therefore, as described above, it is possible to make the circuit pattern 20 denser than the conventional structure.

That is, in Example, the width of the inter-circuit groove portion 110 can be narrowed because the trailing-tailed shape formed near the interface between the insulating layer upper surface 11a and the circuit pattern 20 can be made small. As a result, it is possible to realize a configuration in which the ratio S₂/S₁ of the area S₂ to the area S₁ is 0.1 or more and 0.9 or less. That is, since the width of the inter-circuit groove portion 110 can be narrowed, the degree of freedom in designing the island shape is increased, and the flexibility in the heat radiation design can be improved.

Although the embodiment of the present invention has been described above, the embodiment is an example of the present invention, and various configurations other than the above embodiment can be adopted.

This application claims priority on the basis of Japanese Patent Application No. 2020-096729 filed on June 3, 2020, all of its disclosures are incorporated herein.

### REFERENCE SIGNS LIST

10 heat radiating substrate
11 insulating layer
11a insulating layer upper surface
12 metal substrate
20 circuit pattern
20A, 20B metal layer
101, 201 first circuit pattern
101a inner contour line
110, 210 inter-circuit groove portion
120, 220, 320 second circuit pattern
120b outer contour line
221, 321 second circuit pattern (1)
222, 322 second circuit pattern (2)
311 first inter-circuit groove portion
312 second inter-circuit groove portion

## Claims

1. A circuit board comprising:
an insulating substrate; and
a circuit pattern of a metal provided on the insulating substrate in direct contact with the insulating substrate,
wherein the circuit pattern has a first circuit pattern formed in a first region on the insulating substrate and a second circuit pattern formed in a second region on the insulating substrate, and
the first region surrounds and closes the second region when viewed in a top view.

2. The circuit board according to claim 1,
wherein when an area surrounded by an inner contour line of the first region is denoted by S₁, and an area of a region surrounded by an outer contour line of the second region is denoted by S₂, S₂/S₁ is 0.1 or more and 0.9 or less.

3. The circuit board according to claim 1 or 2,
wherein the insulating substrate consists of a resin substrate.

4. The circuit board according to any one of claims 1 to 3,
wherein the metal consists of rolled copper.
